# FASCICULE DE BREVET EUROPEEN

(11) **EP 3 819 687 B1**
(45) Date de publication et mention de la délivrance du brevet: **25.02.2026**
(21) Numéro de dépôt: 20205385.6
(22) Date de dépôt: 03.11.2020
(51) Int. Cl.: G02B 6/12

(54) **PROCÉDÉ DE FABRICATION D'UN DISPOSITIF PHOTONIQUE INTÉGRÉ**
VERFAHREN ZUR HERSTELLUNG EINER INTEGRIERTEN PHOTONENVORRICHTUNG
METHOD FOR MANUFACTURING AN INTEGRATED PHOTONIC DEVICE

(30) Priorité: 06.11.2019 FR 1912437
(43) Date de publication de la demande: 12.05.2021
(73) Titulaire: Commissariat à l'Energie Atomique et aux Energies Alternatives, 75015 Paris (FR)
(72) Inventeur: HASSAN, Karim, 38054 GRENOBLE CEDEX 9 (FR); SCIANCALEPORE, Corrado, 38054 GRENOBLE CEDEX 9 (FR); SZELAG, Bertrand, 38054 GRENOBLE CEDEX 9 (FR)
(74) Mandataire: Cabinet Beaumont

(56) Documents cités:
- FR-A1- 2 877 142
- US-A1- 2014 254 978
- US-A1- 2015 030 282
- US-A1- 2016 178 861
- US-B1- 8 213 751

## Description

### Domaine technique

La présente description concerne un procédé de fabrication d'un dispositif photonique intégré.

### Technique antérieure

Les procédés connus de fabrication de dispositifs photoniques intégrés présentent divers inconvénients.

Il serait souhaitable de pouvoir disposer d'un procédé de fabrication d'un dispositif photonique intégré, ce procédé palliant tout ou partie des inconvénients des procédés connus. Les documents US8213751, US2016/178861, US2014/254978 et US2015/030282 décrivent des exemples de réalisation de circuits photoniques intégrés.

### Résumé de l'invention

L'invention est définie par la revendication 1.

Selon un mode de réalisation, l'étape de formation de composants photoniques dans lesdites au moins une première et au moins une deuxième vignettes est postérieure à l'étape de report.

Selon un mode de réalisation, le procédé comprend en outre, après l'étape de report, une étape d'amincissement collectif desdites au moins une première et au moins une deuxième vignettes, par meulage mécanique à partir de leurs faces opposées au premier substrat.

Selon un mode de réalisation, le procédé comprend en outre, après l'étape de report, une étape de retrait, par gravure chimique, d'un substrat de croissance de ladite au moins une première vignette, et une étape de retrait, par gravure chimique, d'un substrat de dépôt de ladite au moins une deuxième vignette.

Selon un mode de réalisation, lors de l'étape de report, lesdites au moins une première et au moins une deuxième vignettes sont reportées simultanément sur le circuit photonique au moyen d'un substrat de support temporaire.

Selon un mode de réalisation, lors de l'étape de report, lesdites au moins une première et au moins une deuxième vignettes sont fixées par collage moléculaire sur ladite face du circuit photonique.

Selon un mode de réalisation, le collage moléculaire mis en oeuvre lors de l'étape de report est un collage direct oxyde-oxyde.

Selon un mode de réalisation, chaque deuxième vignette comprend une couche de Si₃N₄ stoechiométrique déposée par LPCVD.

Selon un mode de réalisation, le procédé comprend, avant l'étape de report, une étape de dopage localisé du premier substrat pour la réalisation d'une jonction PN d'un composant du circuit photonique.

Selon un mode de réalisation, le premier substrat est un substrat de type silicium sur isolant.

Selon un mode de réalisation, le substrat de support temporaire est un film souple.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

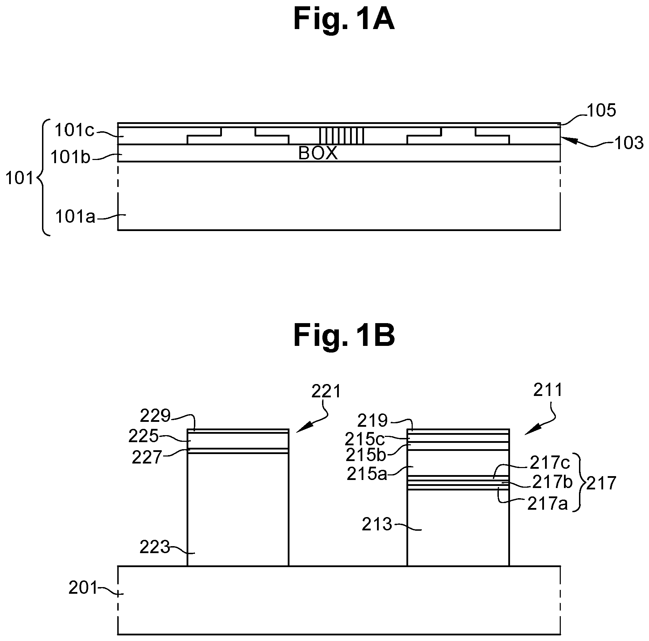

la figure 1A illustre une étape d'un procédé de fabrication d'un dispositif photonique intégré selon un mode de réalisation ;
la figure 1B illustre une autre étape d'un procédé de fabrication d'un dispositif photonique intégré selon un mode de réalisation ;

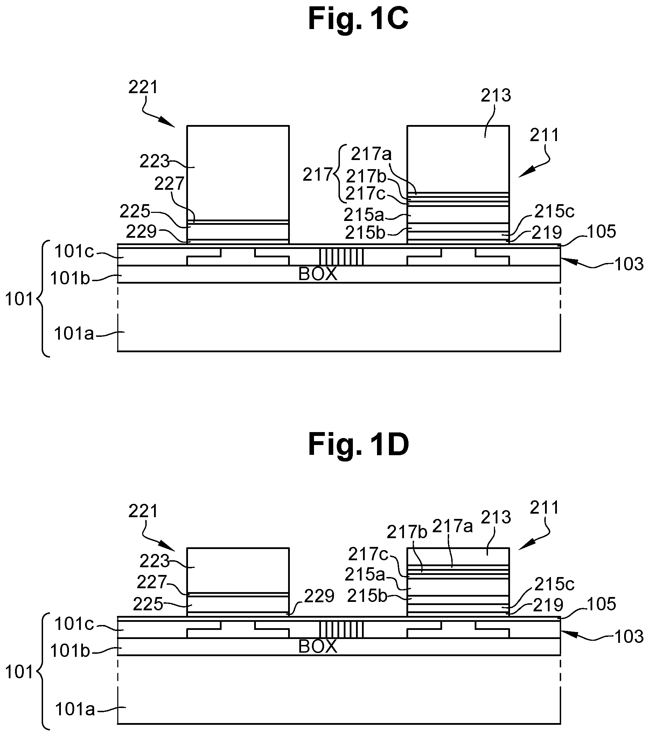

la figure 1C illustre une autre étape d'un procédé de fabrication d'un dispositif photonique intégré selon un mode de réalisation ;
la figure 1D illustre une autre étape d'un procédé de fabrication d'un dispositif photonique intégré selon un mode de réalisation ;

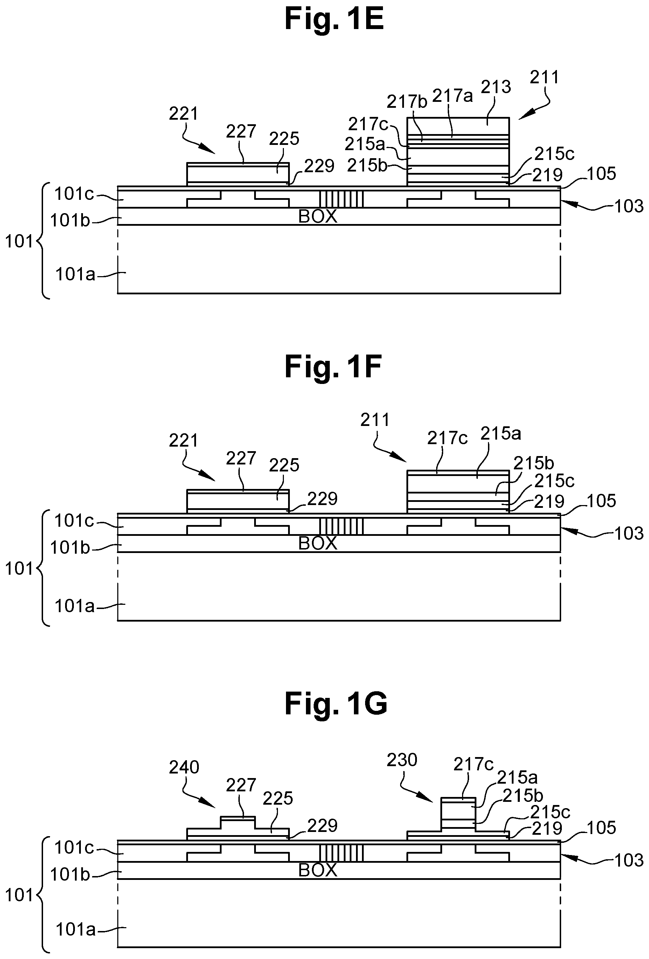

la figure 1E illustre une autre étape d'un procédé de fabrication d'un dispositif photonique intégré selon un mode de réalisation ;
la figure 1F illustre une autre étape d'un procédé de fabrication d'un dispositif photonique intégré selon un mode de réalisation ; et
la figure 1G illustre une autre étape d'un procédé de fabrication d'un dispositif photonique intégré selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différents composants actifs ou passifs que peuvent comporter les dispositifs photoniques réalisés par les procédés décrits n'ont pas été détaillés, les modes de réalisation décrits étant compatibles avec tous ou la plupart des composants usuels des dispositifs photoniques intégrés

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les figures 1A à 1G sont des vues en coupe illustrant de façon schématique et partielle des étapes d'un exemple d'un mode de réalisation d'un procédé de fabrication d'un dispositif photonique intégré.

Par souci de simplification, on a représenté sur les figures 1A à 1G la réalisation d'un unique dispositif photonique. En pratique, une pluralité de dispositifs photoniques identiques ou similaires peuvent être formés simultanément dans et sur un même substrat, le substrat étant ensuite découpé en une pluralité de puces individuelles comportant chacune un unique dispositif photonique.

La figure 1A illustre une structure obtenue à l'issue d'étapes de formation d'un circuit photonique intégré dans un premier substrat 101, par exemple à base de silicium. Le substrat 101 est par exemple un substrat de type SOI (de l'anglais "Silicon On Insulator" - silicium sur isolant), comprenant un support 101a en silicium, une couche isolante 101b, par exemple en oxyde de silicium, disposée sur et en contact avec la face supérieure du support 101a, et une couche de silicium 101c disposée sur et en contact avec la face supérieure de la couche isolante 101b. Les couches 101b et 101c s'étendent par exemple chacune sur sensiblement toute la surface du support 101a. Des composants photoniques actifs ou passifs 103 sont formés dans la couche de silicium supérieure 101c du substrat 101, formant un premier circuit intégré photonique. Les composants 103 comprennent par exemple des guides d'ondes, des réseaux diffractifs, des photodiodes, des modulateurs à jonction PN et/ou tout autre composant photonique susceptible d'être intégré dans un substrat de type SOI. A titre de variante, la couche 101c peut comprendre des régions de germanium ou d'un alliage silicium-germanium, auquel cas les composants 103 peuvent comprendre des composants à base de germanium.

La figure 1A illustre en outre une étape postérieure à la formation des composants 103, de dépôt d'une couche isolante 105, par exemple une couche d'oxyde de silicium, sur la face supérieure du substrat 101. La couche 105 s'étend par exemple de façon continue sur toute la surface du substrat 101. L'épaisseur de la couche 105 est par exemple comprise entre 5 et 100 nm, par exemple entre 70 et 80 nm.

La figure 1B illustre une étape de fixation, sur la face supérieure d'un substrat de support temporaire 201, de premières vignettes 211 à base d'un matériau semiconducteur III-V, et de deuxièmes vignettes 221 à base de nitrure de silicium. Sur la figure 1B, une seule vignette 211 et une seule vignette 221 ont été représentées. Les vignettes 211 et 221 sont destinées à être reportées sur le substrat 101 en vue de former, au-dessus des composants photoniques 103 intégrés dans le substrat 101, des composants photoniques à base du matériau semiconducteur III-V, par exemple des diodes laser, et des composants photoniques à base de nitrure de silicium, par exemple des guides d'onde, destinés à coopérer avec les composants 103 pour former un dispositif photonique.

Le substrat de support temporaire 201 a par exemple sensiblement la même surface que le substrat 101. La disposition des vignettes 211 et 221 sur le substrat 201 correspond à la disposition souhaitée des vignettes après report sur le substrat 101. A titre d'exemple, on peut prévoir de reporter une ou plusieurs vignettes 211 et une ou plusieurs vignettes 221 sur chaque circuit intégré photonique formé dans le substrat 101. Chaque vignette 211 ou 221 peut avoir, en vue de dessus, une dimension minimale comprise entre 1 et 10 mm, par exemple entre 1 et 5 mm. A titre d'exemple, en vue de dessus, chaque vignette 211 ou 221 a une surface comprise entre 1 et 25 mm².

Les vignettes 211 sont formées par épitaxie à partir d'un substrat de croissance 213. Chaque vignette peut comprendre un empilement comportant, dans l'ordre à partir de la face supérieure (dans l'orientation de la figure 1B) du substrat 213, une couche semiconductrice 215a d'un matériau III-V dopé d'un premier type de conductivité, par exemple de type P, une couche active 215b, et une couche semiconductrice 215c d'un matériau III-V dopé du deuxième type de conductivité, par exemple de type N. A titre d'exemple, le substrat 213 et les couches semiconductrices 215a et 215c sont en phosphure d'indium (InP). La couche active 215b peut comprendre des moyens de confinement correspondant à des puits quantiques multiples (succession de puits quantiques et de barrières, entourés par des couches de confinement de type SCH, de l'anglais "Separate Confinement Heterostructure" - hétérostructure de confinement séparée). A titre d'exemple, la couche active 215b comprend une alternance de couches semiconductrices d'un premier matériau III-V et de couches semiconductrices d'un deuxième matériau III-V, chaque couche du premier matériau étant prise en sandwich entre deux couches du deuxième matériau, le premier matériau ayant une bande interdite plus étroite que celle du deuxième matériau. A titre d'exemple, la couche active 215b est disposée sur et en contact avec la face supérieure de la couche 215a, et la couche 215c est disposée sur et en contact avec la face supérieure de la couche active 215b. Chaque vignette 211 peut en outre comprendre un empilement 217 d'une ou plusieurs couches tampon faisant interface entre la face supérieure du substrat 213 et la face inférieure de la couche 215a. Dans l'exemple représenté, l'empilement 217 comprend, dans l'ordre à partir de la face supérieure du substrat 213, une première couche semiconductrice 217a disposée sur et en contact avec la face supérieure du substrat 213, une deuxième couche semiconductrice 217b disposée sur et en contact avec la face supérieure de la couche 217a, et une troisième couche semiconductrice 217c disposée sur et en contact avec la face supérieure de la couche 217b. Dans cet exemple, la face supérieure de la couche 217c est en contact avec la face inférieure de la couche 215a. La couche 217a est destinée à former une première couche d'arrêt de gravure lors d'une étape ultérieure de retrait du substrat 213. La couche 217a est par exemple en arséniure d'indium gallium (InGaAs). La couche 217b est destinée à former une deuxième couche d'arrêt de gravure lors de l'étape ultérieure de retrait du substrat 213. La couche 217b est par exemple en phosphure d'indium. La couche 217c est destinée à former une troisième couche d'arrêt de gravure et une couche de reprise d'un contact électrique avec la couche 215a. La couche 217c est par exemple en arséniure d'indium gallium dopé de type P. Dans cet exemple, chaque vignette 211 comprend en outre une couche isolante 219, par exemple en le même matériau que la couche 105, disposée sur la face supérieure de la couche semiconductrice 215c, par exemple en contact avec la face supérieure de la couche 215c. L'épaisseur de la couche 219 est par exemple comprise entre 5 et 50 nm, par exemple entre 10 et 20 nm.

A titre d'exemple, les couches 217a, 217b, 217c, 215a, 215b et 215c sont formées successivement par épitaxie sur la face supérieure du substrat de croissance 213, avant découpe du substrat 213 en vignettes individuelles. Chacune des couches 217a, 217b, 217c, 215a, 215b et 215c s'étend par exemple de façon continue et sur une épaisseur sensiblement uniforme sur toute la surface supérieure du substrat 213. La couche isolante 219 peut ensuite être déposée sur la face supérieure de la couche semiconductrice 215c. La couche 219 est par exemple déposée de façon à présenter une épaisseur sensiblement constante sur toute la surface supérieure du substrat 213. L'empilement comportant le substrat 213 et les couches 217a, 217b, 217c, 215a, 215b, 215c et 219 peut ensuite être découpé en une pluralité de vignettes 211 individuelles.

Après découpe, chaque vignette 211 peut être fixée au substrat temporaire 201 par la face du substrat 213 opposée aux couches 217a, 217b, 217c, 215a, 215b, 215c et 219, c'est-à-dire par la face inférieure du substrat 213 dans l'orientation de la figure 1B.

Les vignettes 221 sont formées à partir d'un substrat de dépôt 223, par exemple en silicium. Chaque vignette 221 comprend une couche de nitrure de silicium 225 disposée sur la face supérieure (dans l'orientation de la figure 1B) du substrat de dépôt 223. L'épaisseur de la couche 225 est par exemple comprise entre 50 nm et 2000 nm. Chaque vignette 221 peut en outre comprendre une couche diélectrique 227, par exemple en oxyde de silicium, faisant interface entre le substrat 223 et la couche de nitrure de silicium 225. A titre d'exemple, la couche 227 est en contact, par sa face inférieure, avec la face supérieure du substrat 213, et, par sa face supérieure, avec la face inférieure de la couche 225. L'épaisseur de la couche 227 est par exemple comprise entre 100 nm et 2500 nm. Dans cet exemple, chaque vignette 221 comprend en outre une couche isolante 229, par exemple en le même matériau que la couche 105, disposée sur la face supérieure de la couche 225, par exemple en contact avec la face supérieure de la couche 225. L'épaisseur de la couche 229 est par exemple comprise entre 5 et 50 nm, par exemple entre 10 et 20 nm.

Les couches 227, 225 et 229 sont déposées successivement sur la face supérieure du substrat de dépôt 223, avant découpe du substrat 223 en vignettes individuelles. Chacune des couches 227, 225 et 229 s'étend par exemple de façon continue et sur une épaisseur sensiblement uniforme sur toute la surface supérieure du substrat 223. De préférence, la couche 225 est formée par un procédé de dépôt de type LPCVD (de l'anglais "Low-Pressure Chemical Vapor Deposition" - dépôt chimique en phase vapeur basse-pression), par exemple à une température de l'ordre de 800°C. Un tel procédé permet en effet d'obtenir une couche stoechiométrique de Si₃N₄, particulièrement avantageuse pour la formation de composants photoniques. L'empilement comportant le substrat 223 et les couches 227, 225 et 239 peut ensuite être découpé en une pluralité de vignettes 221.

Après découpe, chaque vignette 221 peut être fixée au substrat temporaire 201 par la face du substrat 223 opposée aux couches 227, 225 et 229, c'est-à-dire par la face inférieure du substrat 223 dans l'orientation de la figure 1B.

La fixation des vignettes 211 et 221 au substrat temporaire 201 peut être réalisée au moyen d'une couche adhésive (non représentée) disposée du côté de la face supérieure du substrat 201.

Les vignettes 211 et 213 sont par exemple disposées successivement sur le substrat temporaire 201 au moyen d'un outil de prélèvement et placement ("pick and place" en langue anglaise).

La figure 1C illustre une étape de report et de fixation des vignettes 211 et 221 sur le substrat 101. Lors de cette étape, les vignettes 211 et 221 sont reportées et fixées de façon collective (c'est-à-dire simultanément) sur le substrat 101. Le substrat temporaire 201 (non visible sur la figure 1C) est utilisé comme poignée de support pour le positionnement des vignettes en vis-à-vis des circuits photoniques intégrés dans le substrat 101. Chacune des vignettes 211 et 221 est fixée au substrat 101 par sa face opposée au substrat temporaire 201. Sur la figure 1C, l'orientation du substrat 101 est la même que sur la figure 1A, mais l'orientation des vignettes 211 et 221 est inversée par rapport à la figure 1B.

Dans cet exemple, chaque vignette 211 est fixée au substrat 101 par collage ("bonding" en langue anglaise) direct ou collage moléculaire de la face inférieure de la couche 219 avec la face supérieure de la couche 105. De plus, chaque vignette 221 est fixée au substrat 101 par collage direct ou collage moléculaire de la face inférieure de la couche 229 avec la face supérieure de la couche 105. Un tel collage est rendu possible par le fait que les vignettes 211 et 221 sont reportées simultanément sur le substrat 101. En effet, un tel collage nécessite une préparation de surface du substrat 101. Cette préparation comprend par exemple au moins une étape d'activation plasma, et une étape de polissage mécano-chimique (CMP). Pour mettre en oeuvre cette préparation de surface, il convient que la surface de collage du substrat 101 soit libre de toute vignette.

Après fixation des vignettes sur le substrat 101, le substrat de support temporaire 201 est retiré.

Les épaisseurs des vignettes 211 et 221 sont de préférence sensiblement identiques, de façon à faciliter le collage des vignettes sur le substrat 101. Pour obtenir des vignettes 211 et 221 ayant sensiblement la même épaisseur, une étape d'amincissement du substrat 223 par sa face opposée à la couche 229, et/ou une étape d'amincissement du substrat 213 par sa face opposée à la couche 219, peuvent être prévues avant l'étape de découpe des vignettes.

Le substrat de support temporaire 201 peut être un substrat relativement rigide, par exemple un substrat en silicium. Dans ce cas, la différence maximale d'épaisseur entre deux vignettes est de préférence inférieure à 10 µm, de façon à garantir l'obtention d'un contact entre chaque vignette et la couche 105 revêtant le substrat 101. Dans le cas où le substrat de support temporaire 201 est rigide, ce dernier peut comporter des cavités (non représentées) qui maintiennent latéralement chaque vignette (une cavité par vignette) lors du report. Les cavités peuvent avoir une profondeur inférieure à l'épaisseur des vignettes. A titre de variante, les vignettes dépassent des cavités d'une hauteur comprise entre 10 et 100 µm, par exemple d'une hauteur de l'ordre de 50 µm. La profondeur des cavités est par exemple de l'ordre de 300 µm.

A titre de variante, le substrat de support temporaire 201 peut être un film souple, par exemple un film plastique. Lors du report, un rouleau peut être passé sur la face du film opposée aux vignettes, de façon à mettre en contact chaque vignette avec la couche 105 revêtant le substrat 101. Dans ce cas, la marge de tolérance sur l'épaisseur des vignettes peut être plus importante. De préférence, la différence maximale d'épaisseur entre deux vignettes est alors inférieure à 50 µm. On notera que dans cette variante, plus les vignettes sont éloignées les unes des autres, plus la différence d'épaisseur entre deux vignettes peut être importante. A titre d'exemple, la différence d'épaisseur entre deux vignettes peut aller jusqu'à 50 µm entre deux vignettes distantes de 8 mm ou plus, et n'excédera de préférence pas 10 µm entre deux vignettes séparées par une distance de l'ordre de 400 µm. Une règle linéaire peut être définie entre l'espacement entre deux vignettes et la différence maximale tolérable entre ces deux vignettes. A titre d'exemple, cette règle peut s'exprimer comme suit : δₕ=5.26*10⁻³*E+7.89, où δₕ est la différence d'épaisseur maximale acceptable entre deux vignettes et E est l'espacement latéral entre lesdites deux vignettes, par exemple compris dans la plage allant de 400 µm à 32000 µm.

La figure 1D illustre une étape postérieure à l'étape de report de la figure 1C, au cours de laquelle on vient amincir simultanément les vignettes 211 et 221 par meulage ("grinding" en langue anglaise), par leur face opposée au substrat 101. Lors de cette étape, le substrat 213 de chaque vignette 211 et le substrat 223 de chaque vignette 221 sont partiellement retirés. A l'issue de l'étape d'amincissement, les vignettes 211 et 221 ont sensiblement la même épaisseur, par exemple comprise entre 20 et 80 µm, par exemple entre 30 et 60 µm. A titre de variante, cette étape d'amincissement peut être omise si les vignettes ont été suffisamment pré-amincies avant découpe (paragraphe [0044]), par exemple de façon à présenter une épaisseur inférieure ou égale à 150 µm, par exemple de l'ordre de 100 µm, lors de l'étape de report. Ceci est tout particulièrement avantageux lorsque le substrat de support temporaire 201 est un film souple. En effet, ceci permet alors de limiter le risque d'arrachement ou de déplacement des vignettes pendant l'amincissement.

La figure 1E illustre une étape postérieure à l'étape d'amincissement de la figure 1D, au cours de laquelle on vient retirer le reste du substrat 223 des vignettes 221. Dans cet exemple, le substrat 223 est retiré par un procédé de gravure humide sélectif. A titre d'exemple, le substrat 223 est retiré au moyen d'une solution apte à graver le matériau du substrat 223 de façon sélective par rapport au matériau de la couche 227, par exemple une solution à base d'hydroxyde de tétraméthylammonium (TMAH) ou à base d'acide nitrique (HNO₃). La gravure s'interrompt au niveau de la face supérieure de la couche 227 des vignettes 221. Lors de cette étape, le substrat 213 des vignettes 211 est préservé.

La figure 1F illustre une étape postérieure à l'étape d'amincissement de la figure 1D, au cours de laquelle on vient retirer le substrat 213 des vignettes 211. Cette étape est par exemple postérieure à l'étape de la figure 1E de retrait du substrat 223 des vignettes 221. Dans cet exemple, le substrat 213 est retiré par un procédé de gravure humide sélectif. A titre d'exemple, lors d'une première phase de gravure, le substrat 213 est retiré au moyen d'une solution apte à graver le matériau du substrat 213 de façon sélective par rapport au matériau de la couche 217a, par exemple une solution à base d'acide chlorhydrique (HCl) et d'eau (H₂O). Une deuxième phase de gravure peut ensuite être mise en oeuvre au moyen d'une solution apte à graver le matériau de la couche 217a de façon sélective par rapport au matériau de la couche 217b, par exemple une solution à base acide sulfurique (H₂SO₄), de peroxyde d'hydrogène (H₂O₂) et d'eau (H₂O). Une troisième phase de gravure peut ensuite être mise en oeuvre au moyen d'une solution apte à graver le matériau de la couche 217b de façon sélective par rapport au matériau de la couche 217c, par exemple une solution à base d'acide chlorhydrique (HCl) et d'eau (H₂O). La gravure s'interrompt au niveau de la face supérieure de la couche 217c.

La figure 1G illustre de façon très schématique des étapes ultérieures de formation de composants photoniques 230, par exemple des diodes laser, à partir des vignettes 211, et de composants photoniques 240, par exemple des guides d'onde, à partir des vignettes 221. La réalisation des composants 230 et 240 comprend notamment des étapes de structuration des différents matériaux des vignettes 211 et 221, par exemple par des procédés de lithographie et gravure. La réalisation des composants 230 et 240 n'a pas été détaillée, les modes de réalisation décrits étant compatibles avec les réalisations usuelles de composants photoniques à base de matériaux semiconducteurs III-V et à base de nitrure de silicium.

Une fois les composants 230 et 240 formés, une ou plusieurs couches d'encapsulation (non représentées) peuvent être déposées sur la face supérieure de la structure. Des vias conducteurs (non représentés) peuvent en outre être formés à travers la couche d'encapsulation pour permettre la reprise de contacts électriques sur des composants actifs du dispositif. Le substrat 101 peut ensuite être découpé en une pluralité de puces individuelles comportant chacune un unique dispositif photonique hétérogène comportant un ou plusieurs composants 103, un ou plusieurs composants 230, et un ou plusieurs composants 240.

Un avantage du procédé décrit en relation avec les figures 1A à 1G est qu'il permet d'intégrer de façon monolithique, dans et sur un même substrat 101, des composants photoniques de différentes natures. Les composants à base de matériaux III-V et les composants à base de nitrure de silicium sont avantageusement disposés du côté d'une même face du circuit photonique préalablement formé dans le substrat 101. En outre, la couche de nitrure de silicium 225 servant de base à la formation des composants 230 peut avantageusement être préparée par un procédé de type LPCVD à haute température, sans risquer d'endommager les composants 103 du substrat 101. Ceci est notamment avantageux lorsque les composants 103 comprennent au moins une jonction PN présentant un profil de diffusion contrôlé, par exemple pour la réalisation d'un modulateur ou d'une photodiode.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que l'on ait décrit ci-dessus un exemple de procédé dans lequel des vignettes de deux types différents sont reportées sur le substrat 101, les modes de réalisation décrits dans des variantes qui ne sont pas incluses dans l'objet des revendications ne se limitent pas à ce cas particulier. A titre de variante, outre des vignettes à base d'un matériau semiconducteur III-V et des vignettes à base de nitrure de silicium, dans un mode de réalisation qui n'est pas inclus dans l'objet des revendications des vignettes d'un ou plusieurs autres types différents peuvent être reportées sur le substrat 101 lors de l'étape de la figure 1C.

En outre, bien que l'on ait décrit ci-dessus un exemple de réalisation dans lequel les vignettes sont d'abord fixées au substrat 101, puis structurées pour former des composants 230, 240, les modes de réalisation décrits dans des variantes qui ne sont pas incluses dans l'objet des revendications ne se limitent pas à ce cas particulier. A titre de variante, dans un mode de réalisation qui n'est pas inclus dans l'objet des revendications les vignettes peuvent être structurées pour former des composants 230, 240 avant d'être reportées sur le substrat 101. En particulier, dans un mode de réalisation qui n'est pas inclus dans l'objet des revendications les composants 240 à base de nitrure de silicium peuvent être formés avant découpe des vignettes, par exemple par un procédé du type décrit dans l'article intitulé "Photonic Damascene Process for Low-Loss, High-Confinement Silicon Nitride Waveguides" de M. H. P. Pfeiffer et al. (IEEE JSTQE vol.24, no.4, 2018).

De plus, bien que l'on ait décrit ci-dessus un exemple de procédé dans lequel des vignettes de natures différentes sont reportées collectivement (i.e. simultanément) sur la face supérieure du substrat 101, les modes de réalisation décrits dans des variantes qui ne sont pas incluses dans l'objet des revendications ne se limitent pas à ce cas particulier. A titre de variante, dans un mode de réalisation qui n'est pas inclus dans l'objet des revendications les différentes vignettes peuvent être reportées successivement sur le substrat 101, par exemple au moyen d'un outil de prélèvement et placement.

## Revendications

1. Procédé de fabrication d'un dispositif photonique, comprenant les étapes suivantes :
- former au moins une première vignette (211) à base d'un matériau semiconducteur III-V par épitaxie à partir d'un substrat de croissance (213), et au moins une deuxième vignette (221) à base de nitrure de silicium à partir d'un substrat de dépôt (223), ladite au moins une première vignette (211) et ladite au moins une deuxième vignette (221) étant de natures différentes ;
- après découpe du substrat de croissance (213) en ladite au moins une première vignette (211) et du substrat de dépôt (223) en ladite au moins une deuxième vignette (221), fixer ladite au moins une première (211) vignette et ladite au moins une deuxième vignette (221) sur une face d'un substrat de support temporaire (201) ; et
- reporter simultanément ladite au moins une première vignette (211) et ladite au moins une deuxième vignette (221), au moyen du substrat de support temporaire, sur une même face d'un circuit photonique préalablement formé dans et sur un premier substrat (101),
le procédé comprenant en outre une étape de formation de composants photoniques (230, 240) dans lesdites au moins une première (211) et au moins une deuxième (221) vignettes.

2. Procédé selon la revendication 1, dans lequel l'étape de formation de composants photoniques (230, 240) dans lesdites au moins une première (211) et au moins une deuxième (221) vignettes est postérieure à l'étape de report.

3. Procédé selon la revendication 1 ou 2, comprenant en outre, après l'étape de report, une étape d'amincissement collectif desdites au moins une première (211) et au moins une deuxième (221) vignettes, par meulage mécanique à partir de leurs faces opposées au premier substrat (101).

4. Procédé selon l'une quelconque des revendications 1 à 3, comprenant en outre, après l'étape de report, une étape de retrait, par gravure chimique, du substrat de croissance (213) de ladite au moins une première vignette (211), et une étape de retrait, par gravure chimique, du substrat de dépôt (223) de ladite au moins une deuxième vignette (221).

5. Procédé selon l'une quelconque des revendications 1 à 4, dans lequel, lors de l'étape de report, lesdites au moins une première (211) et au moins une deuxième (221) vignettes sont fixées par collage moléculaire sur ladite face du circuit photonique.

6. Procédé selon la revendication 5, dans lequel le collage moléculaire mis en oeuvre lors de l'étape de report est un collage direct oxyde-oxyde.

7. Procédé selon l'une quelconque des revendications 1 à 6, dans lequel chaque deuxième vignette (221) comprend une couche (225) de Si₃N₄ stoechiométrique déposée par LPCVD.

8. Procédé selon la revendication 7, comprenant, avant l'étape de report, une étape de dopage localisé du premier substrat (101) pour la réalisation d'une jonction PN d'un composant (103) du circuit photonique.

9. Procédé selon l'une quelconque des revendications 1 à 7, dans lequel le premier substrat (101) est un substrat de type silicium sur isolant.

10. Procédé selon l'une quelconque des revendications 1 à 9, dans lequel le substrat de support temporaire (201) est un film souple.

## Patentansprüche

1. Ein Verfahren zur Herstellung einer photonischen Einrichtung, das die folgenden Schritte aufweist:
- Ausbilden wenigstens eines ersten Dies (211) auf der Basis eines III-V-Halbleitermaterials durch Epitaxie aus einem Wachstumssubstrat (213) und wenigstens eines zweiten Dies (221) auf der Basis von Siliziumnitrid aus einem Abscheidungssubstrat (223), wobei der wenigstens eine erste Die (211) und der wenigstens eine zweite Die (221) unterschiedlicher Art sind;
- nach Zerschneiden des Wachstumssubstrats (213) in den wenigstens einen ersten Chip (211) und des Abscheidungssubstrats (223) in den wenigstens einen zweiten Chip (221) Befestigen des wenigstens einen ersten Chips (211) und des wenigstens einen zweiten Chips (221) auf einer Oberfläche eines temporären Trägersubstrats (201); und
- gleichzeitiges Übertragen des wenigstens einen ersten Chips (211) und des wenigstens einen zweiten Chips (221) mittels des temporären Trägersubstrats auf eine gleiche Oberfläche eines photonischen Schaltkreises, der zuvor innerhalb und auf einem ersten Substrat (101) ausgebildet wurde,
wobei das Verfahren ferner einen Schritt des Ausbildens von photonischen Komponenten (230, 240) in dem wenigstens einen ersten (211) und dem wenigstens einen zweiten (221) Chip aufweist.

2. Das Verfahren nach Anspruch 1, wobei der Schritt des Ausbildens von photonischen Komponenten (230, 240) in dem wenigstens einen ersten (211) und wenigstens einen zweiten (221) Die nach dem ÜbertragungsSchritt erfolgt.

3. Das Verfahren nach Anspruch 1 oder 2, das nach dem Übertragungsschritt einen Schritt des gemeinsamen Ausdünnens des wenigstens einen ersten (211) und des wenigstens einen zweiten (221) Dies durch mechanisches Schleifen von ihren Oberflächen gegenüber dem ersten Substrat (101) aufweist.

4. Das Verfahren nach einem der Ansprüche 1 bis 3, das nach dem Übertragungsschritt ferner einen Schritt des Entfernens, durch chemisches Ätzen, des Wachstumssubstrats (213) des wenigstens einen ersten Dies (211) und einen Schritt des Entfernens, durch chemisches Ätzen, des Abscheidungssubstrats (223) des wenigstens einen zweiten Dies (221) aufweist.

5. Das Verfahren nach einem der Ansprüche 1 bis 4, wobei während des Übertragungsschritts der wenigstens eine erste (211) und der wenigstens eine zweite (221) Die durch molekulare Bindung auf der Oberfläche der photonischen Schaltung befestigt werden.

6. Das Verfahren nach Anspruch 5, wobei die molekulare Bindung, die während des Übertragungsschritts durchgeführt wird, eine direkte Oxid-zu-Oxid-Bindung ist.

7. Das Verfahren nach einem der Ansprüche 1 bis 6, wobei jeder zweite Die (221) eine stöchiometrische Si3N4-Schicht (225) aufweist, die durch LPCVD abgeschieden wurde.

8. Das Verfahren nach Anspruch 7, aufweisend vor dem Übertragungsschritt einen Schritt des lokalen Dotierens des ersten Substrats (101) zum Ausbilden eines PN-Übergangs einer Komponente (103) der photonischen Schaltung.

9. Das Verfahren nach einem der Ansprüche 1 bis 7, wobei das erste Substrat (101) ein Substrat vom Typ Silizium auf Isolator ist.

10. Verfahren nach einem der Ansprüche 1 bis 9, wobei das temporäre Trägersubstrat (201) ein flexibler Film ist.

## Claims

1. A photonic device manufacturing method, comprising the following steps:
- forming at least one first die (211) based on a III-V semiconductor material by epitaxy from a growth substrate (213), and at least one second die (221) based on silicon nitride from a deposition substrate (223), said at least one first die (211) and said at least one second die (221) being of different nature;
- after dicing of the growth substrate (213) into said at least one first die (211) and of the deposition substrate (223) into said at least on second die (221), affixing said at least one first die (211) and said at least on second die (221) on a surface of a temporary support substrate (201); and
- transferring simultaneously said at least one first die (211) and said at least on second die (221), by means of the temporary support substrate, onto a same surface of a photonic circuit previously formed inside and on top of a first substrate (101),
the method further comprising a step of forming of photonic components (230, 240) in said at least one first (211) and at least one second (221) dies.

2. The method according to claim 1, wherein the step of forming of photonic components (230, 240) in said at least one first (211) and at least one second (221) dies is subsequent to the transfer step.

3. The method according to claim 1 or 2, further comprising, after the transfer step, a step of collective thinning of said at least one first (211) and at least one second (221) dies, by mechanical grinding from their surfaces opposite to the first substrate (101).

4. The method according to any of claims 1 to 3, further comprising, after the transfer step, a step of removal, by chemical etching, of the growth substrate (213) of said at least one first die (211), and a step of removal, by chemical etching, of the deposition substrate (223) of said at least one second die (221).

5. The method according to any of claims 1 to 4, wherein, during the transfer step, said at least one first (211) and at least one second (221) dies are fastened by molecular bonding onto said surface of the photonic circuit.

6. The method according to claim 5, wherein the molecular bonding implemented during the transfer step is a direct oxide-to-oxide bonding.

7. The method according to any of claims 1 to 6, wherein each second die (221) comprises a stoichiometric Si₃N₄ layer (225) deposited by LPCVD.

8. The method according to claim 7, comprising, before the transfer step, a step of local doping of the first substrate (101) for the forming of a PN junction of a component (103) of the photonic circuit.

9. The method according to any of claims 1 to 7, wherein the first substrate (101) is a substrate of silicon on insulator type.

10. The method according to any of claims 1 to 9, wherein the temporary support substrate (201) is a flexible film.
